# EUROPEAN PATENT APPLICATION

(11) **EP 4 803 468 A1**
(43) Date of publication of application: **09.09.2026**
(21) Application number: 24907803.1
(22) Date of filing: 15.11.2024
(51) Int. Cl.: B66B 1/46, B66B 1/52, H03K 17/94

(54) **CONTACTLESS DESTINATION FLOOR INPUT DEVICE FOR ELEVATOR**

(30) Priority: 18.12.2023 KR 20230184675
(71) Applicant: Ilion Co., Ltd., Goyang-si, Gyeonggi-do 10442 (KR)
(72) Inventor: BYUN, Hoonsuk, Goyang-si Gyeonggi-do 10417 (KR)
(74) Representative: De Vries & Metman
(86) International application number: PCT/KR2024/018071
(87) International publication number: WO 2025/135518

(57) **Abstract**

A non-contact destination floor input device for an elevator includes: a proximity sensing module installed at a periphery of an elevator control panel having a plurality of touch buttons, the proximity sensing module recognizing entry of an object into a sensing area at a predetermined distance from the touch buttons; and a non-contact input controller configured to receive a signal from the proximity sensing module, calculate an approach position of the object that has entered the sensing area, and cause at least one of the plurality of touch buttons to be selected based on a result of the calculation. The non-contact input device for an elevator can prevent erroneous registration of a destination floor by a user.

## Description

### TECHNICAL FIELD

The present invention relates to a non-contact destination floor input device for an elevator, and more particularly, to a non-contact input device for an elevator capable of preventing erroneous registration of a destination floor by a user.

### BACKGROUND OF THE INVENTION

In high-rise buildings such as office buildings or apartments, an elevator is installed to facilitate vertical movement. A user who has boarded the elevator can usually move to a destination floor or open and close the elevator door by pressing, with a finger, a touch button of the elevator on which a floor number is displayed.

A conventional elevator touch button is of a push type or a capacitive type that senses a change in capacitance, but in any case, contact with a finger is unavoidable. Recently, the hygiene of public facilities has been considered as an important issue, and in particular, methods of minimizing contact of hands, on which contaminants are abundantly present, have been studied. Therefore, in order to reduce the spread of infectious diseases caused by elevator touch buttons installed in subway stations, airports, hospitals, and the like, structures have been proposed which are capable of registering a destination floor in a non-contact manner and which can be easily applied to existing installed elevators. However, since a destination floor is input in the non-contact manner, erroneous registration occurs due to various manipulations by the user.

### SUMMARY OF THE INVENTION

An object of the present invention is to provide a non-contact destination floor input device for an elevator capable of preventing erroneous registration caused by user manipulation.

To achieve the above object, the present invention provides a non-contact destination floor input device for an elevator, the device including: a proximity sensing module installed at a periphery of an elevator control panel having a plurality of touch buttons, the proximity sensing module recognizing entry of an object into a sensing area at a predetermined distance from the touch buttons; and a non-contact input controller configured to receive a signal from the proximity sensing module, calculate an approach position of the object that has entered the sensing area, and cause at least one of the plurality of touch buttons to be selected based on a result of the calculation.

Preferably, when two or more objects enter the sensing area, the non-contact input controller processes only the object that first entered the sensing area as a valid input.

Preferably, when a second object enters the sensing area in a state in which entry of a first object into the sensing area has been recognized, the non-contact input controller ignores the entry of the second object.

Preferably, when a second object enters the sensing area in a state in which a first object has entered a region of the sensing area corresponding to an OPEN button among the plurality of touch buttons, the non-contact input controller processes the entry of the second object as a valid input.

Preferably, after all objects have departed from the sensing area, the non-contact input controller processes a subsequent entry of an object into the sensing area as a valid input.

Preferably, when a cross-sectional size of an object that has entered the sensing area is equal to or larger than a predetermined size, the non-contact input controller ignores the entry of the object.

Preferably, when the entered object is recognized as crossing a boundary of a region of the sensing area corresponding to one of the plurality of touch buttons, the non-contact input controller ignores the entry of the object.

Preferably, when two or more objects enter the sensing area within a predetermined time and at least one of the objects enters a region of the sensing area that does not correspond to any one of the plurality of touch buttons, the non-contact input controller ignores all entries of the two or more objects.

According to the present invention having the configuration described above, erroneous registration caused by user manipulation can be prevented in a non-contact destination floor input device for an elevator.

### BRIEF DESCRIPTION OF THE DRAWINGS

FIG. 1 is a configuration diagram of an elevator control panel to which a non-contact destination floor input device according to an embodiment of the present invention is applied.
FIG. 2 is a cross-sectional view of the elevator control panel shown in FIG. 1.
FIG. 3 is a view illustrating a detailed configuration and operation of the non-contact destination floor input device shown in FIG. 1.
FIG. 4 is a view illustrating a detailed operation of the non-contact destination floor input device shown in FIG. 1.
FIG. 5A is a view illustrating an operation of the non-contact destination floor input device shown in FIG. 1 when two or more objects enter a sensing area, and FIG. 5B is a view illustrating entry times of the objects.
FIG. 6A is a view illustrating an operation of the non-contact destination floor input device shown in FIG. 1 when a second object enters the sensing area in a state in which entry of a first object into the sensing area has been recognized, and FIG. 6B is a view illustrating entry times of the objects.
FIG. 7A is a view illustrating an operation of the non-contact destination floor input device shown in FIG. 1 when a new object enters the sensing area after all objects have departed from the sensing area, and FIG. 7B is a view illustrating entry times of the objects.
FIG. 8 is a view illustrating an operation of the non-contact destination floor input device shown in FIG. 1 when a cross-sectional size of an object that has entered the sensing area is equal to or larger than a predetermined size.
FIG. 9 is a view illustrating an operation of the non-contact destination floor input device shown in FIG. 1 when an object that has entered the sensing area is recognized as crossing a boundary of a region of the sensing area corresponding to a touch button.
FIG. 10 is a view illustrating an operation of the non-contact destination floor input device shown in FIG. 1 when two or more objects enter the sensing area within a predetermined time and at least one of the objects enters a sensing region that does not correspond to any touch button.

### DETAILED DESCRIPTION OF THE INVENTION

Hereinafter, preferred embodiments of the present invention will be described with reference to the accompanying drawings in order to fully understand the present invention. The embodiments of the present invention may be modified in various forms, and the scope of the present invention should not be construed as being limited to the embodiments described in detail below. The present embodiments are provided so as to more completely convey the present invention to those of ordinary skill in the art. Therefore, in order to emphasize a clearer description, the shapes and the like of elements in the drawings may be exaggerated. It should be noted that, in each drawing, the same members may be denoted by the same reference numerals. Detailed descriptions of well-known functions and configurations that may unnecessarily obscure the gist of the present invention are omitted.

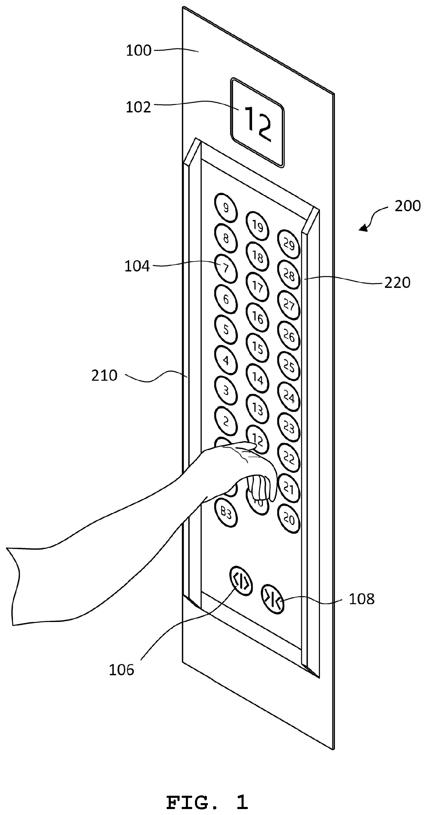

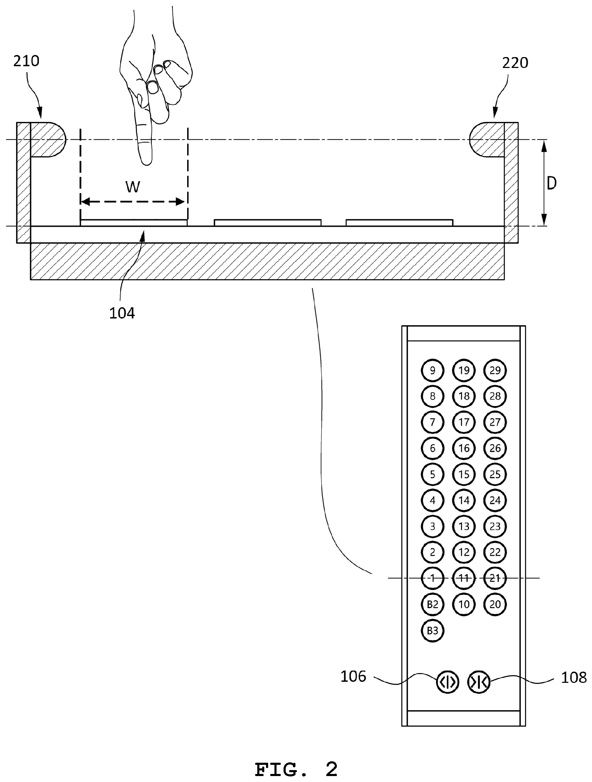

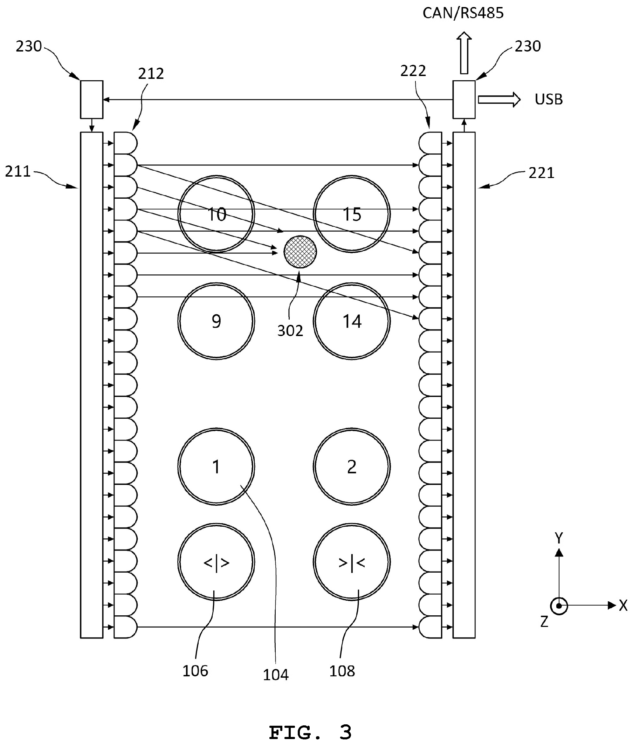

FIG. 1 is a configuration diagram of an elevator control panel 100 to which a non-contact destination floor input device 200 according to an embodiment of the present invention is applied. FIG. 2 is a cross-sectional view of the elevator control panel shown in FIG. 1, and FIG. 3 is a view illustrating a detailed configuration and operation of the non-contact destination floor input device 200 shown in FIG. 1.

As shown in FIG. 1, the elevator control panel 100 includes a display unit 102 that displays a floor number at which the elevator is located, and touch buttons 104, 106, and 108. The touch button 104 designates a destination floor, the touch button 106 is an "OPEN" button for instructing that an opened state of an elevator door be maintained, and the touch button 108 is a "CLOSE" button for instructing that the elevator door be closed. The non-contact destination floor input device 200 according to the present embodiment is installed at a periphery of the touch buttons 104, 106, and 108 (or of the control panel 100).

As shown in FIG. 2, the non-contact destination floor input device 200 includes a proximity sensing module that recognizes entry of an object into a sensing area at a predetermined distance from the touch buttons 104, 106, and 108. The proximity sensing module includes a sensing signal transmitting module 210 and a sensing signal receiving module 220.

The sensing signal transmitting module 210 and the sensing signal receiving module 220 face each other and are arranged to transmit and receive light, in a direction parallel to the touch buttons 104, 106, and 108, at a height (D) spaced apart from the touch buttons 104, 106, and 108. For example, the sensing signal transmitting module 210 and the sensing signal receiving module 220 may be arranged at a height (D) spaced apart by approximately 1 to 10 cm from the plane of the elevator control panel 100 on which the touch buttons 104, 106, and 108 are formed, so that an infrared signal travels in a direction parallel to the elevator control panel 100.

As shown in FIG. 3, the sensing signal transmitting module 210 includes a sensing signal transmitting module driver 211, and the sensing signal receiving module 220 includes a sensing signal receiving module driver 221. The sensing signal transmitting module driver 211 controls a sensing signal transmitting device, for example, an infrared transmitter 212, and the sensing signal receiving module driver 221 controls a sensing signal receiving device, for example, an infrared receiver 222. In addition, the sensing signal transmitting module driver 211 and the sensing signal receiving module driver 221 transmit and receive signals to and from an elevator controller (not shown) that controls operation of the elevator, through a non-contact input controller 230. The non-contact input controller 230 receives the signals from the sensing signal transmitting module driver 211 and the sensing signal receiving module driver 221, calculates an approach position of an object that has entered the sensing area, and causes at least one of the plurality of touch buttons 104, 106, and 108 to be selected based on a result of the calculation. As shown in FIG. 2, a sensing area corresponding to a width (W) of the touch button 104 is mapped to the touch button 104. When a finger 302 of a user is positioned in the sensing area corresponding to the touch button 104, the non-contact input controller 230 causes the elevator controller to control the operation of the elevator as if the user has touched the touch button 104.

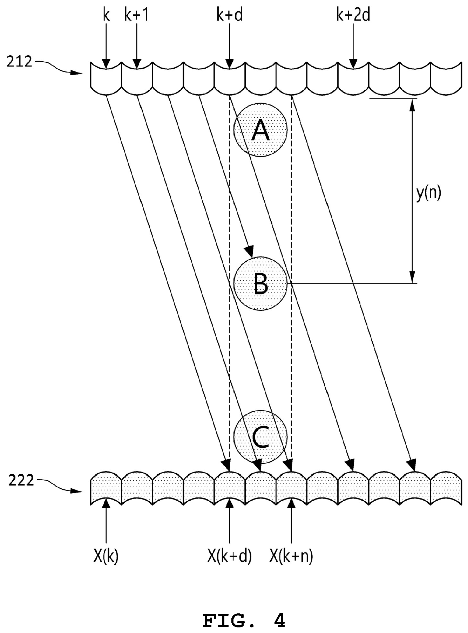

FIG. 4 is a view illustrating a detailed operation of the non-contact destination floor input device 200 shown in FIG. 1.

The infrared transmitter 212 and the infrared receiver 222 are arranged to face each other. In addition, in order to minimize disturbance caused by an external infrared signal such as sunlight, the infrared transmitter 212 and the infrared receiver 222 may also be formed on both sides of the elevator control panel 100. The infrared transmitters 212 are arranged along the Y-axis direction in the order of k, k+1, k+d, k+2d, and the infrared receivers 222 may be arranged along the Y-axis direction in the order of X(k), X(k+d), ..., X(k+n). Here, "d" denotes a position of an infrared receiver 222 located at an oblique angle at which the infrared ray transmitted from the k-th infrared transmitter 212 arrives, and is a factor that determines the magnitude of the oblique angle indicating the inclination of the infrared ray transmitted from the infrared transmitter 212.

A, B, and C shown in FIG. 4 are examples of sensing areas. The user may select one of A, B, and C to perform a touch, or may simultaneously perform a multi-touch. A touch object positioned in the sensing area blocks the infrared signal. That is, the touch object blocks the infrared signal that is output from the infrared transmitter 212 and is to be input to the infrared receiver 222. For example, when an infrared signal is transmitted from a specific infrared transmitter 212, the infrared receivers 222 arranged at various positions, such as at acute, right, and obtuse angle positions with respect to the infrared transmitter 212, are caused to operate while sequentially scanning, and further, while the infrared transmitters 212 at various positions are caused to operate, the infrared receivers 222 are caused to receive the infrared signal, whereby the non-contact destination floor input device 200 can sense the X-axis coordinate of the touch object.

A process of sensing the Y-axis coordinate, such as y(n), is the same as the process of sensing the X-axis coordinate. While the infrared transmitters 212 and the infrared receivers 222 are sequentially operated, the Y-axis coordinate can be sensed by detecting a position at which the infrared signal is blocked and not received.

The infrared transmitter 212 and the infrared receiver 222 may be configured in various forms in order to sense an approach motion of the user. As shown in FIGS. 3 and 4, the infrared transmitter 212 may be arranged on one side and the infrared receiver 222 may be arranged opposite thereto on the other side, or the infrared transmitters 212 and the infrared receivers 222 may be alternately arranged on both sides. In addition, the sensing signal transmitting module driver 211 and the sensing signal receiving module driver 221 may use various scanning schemes and control schemes in order to accurately sense a selection by the user.

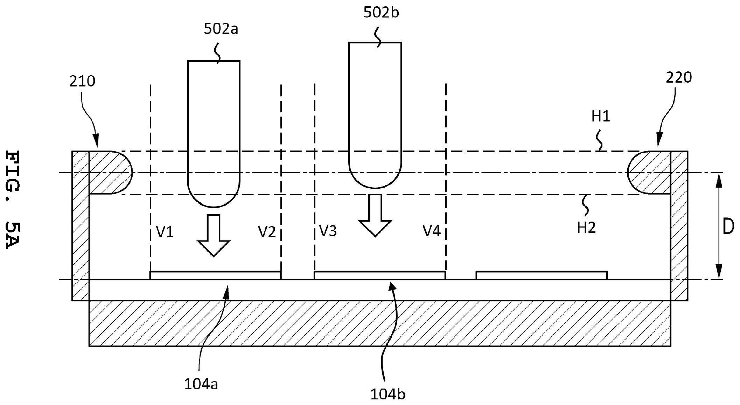

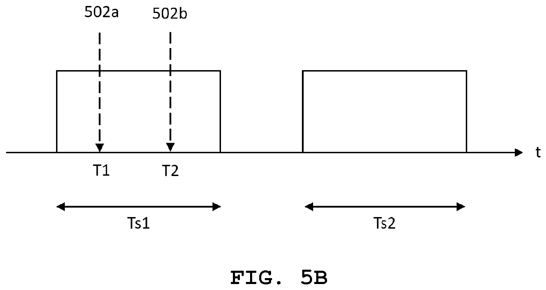

FIG. 5A is a view illustrating an operation of the non-contact destination floor input device 200 shown in FIG. 1 when two or more objects 502a and 502b enter a sensing area within the same sensing cycle (Ts), and FIG. 5B is a view illustrating entry times.

A sensing area is formed between a horizontal plane (H1) and a horizontal plane (H2) according to a vertical position and direction of the infrared transmitter 212 and the infrared receiver 222. Among the sensing areas, the non-contact input controller 230 maps a region (between V1 and V2) located above the touch button 104a to the touch button 104a, and maps a region (between V3 and V4) located above the touch button 104b to the touch button 104b. Since the non-contact input controller 230 senses entry of an object during a predetermined-length sensing time (Ts) that occurs periodically, the non-contact input controller 230 senses both objects when two or more objects 502a and 502b enter during the same sensing cycle (e.g., Ts1). When the object 502a is sensed as having entered the sensing area corresponding to the touch button 104a at time T1 and the object 502b is sensed as having entered the sensing area corresponding to the touch button 104b at time T2, the non-contact input controller 230 determines an order in which the sensed objects 502a and 502b have entered the sensing area, and selects the touch button 104a corresponding to the sensing area in which the first-entering object 502a is positioned. Accordingly, the non-contact destination floor input device 200 can prevent erroneous registration of a destination floor caused by entry of another body part into the sensing area together with a finger for designating the destination floor.

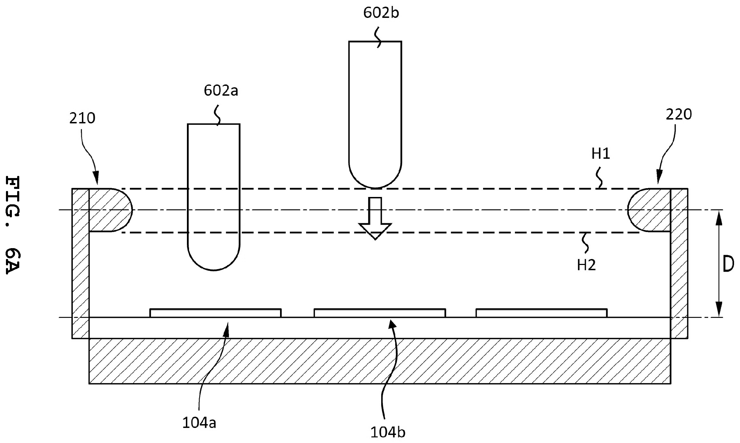

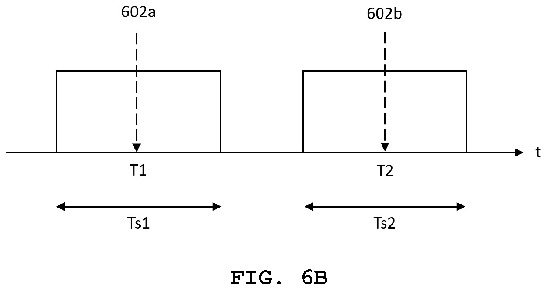

FIG. 6A is a view illustrating an operation of the non-contact destination floor input device 200 shown in FIG. 1 when an object 602b enters a sensing area during a sensing cycle (Ts2) in a state in which an object 602a has been recognized as having entered the sensing area during a sensing cycle (Ts1), and FIG. 6B is a view illustrating entry times of the objects 602a and 602b.

When the object 602b is sensed as having entered the sensing area at time T2 during a different sensing cycle (Ts2) in a state in which the non-contact input controller 230 has recognized that the object 602a has entered the sensing area corresponding to the touch button 104a at time T1 during the sensing cycle (Ts1), the non-contact input controller 230 ignores the entry of the object 602b into the sensing area and does not perform an operation of selecting a touch button with respect to the entry of the object 602b. Accordingly, the non-contact destination floor input device 200 can prevent erroneous registration of a destination floor caused by entry of another body part into the sensing area together with a finger for designating the destination floor.

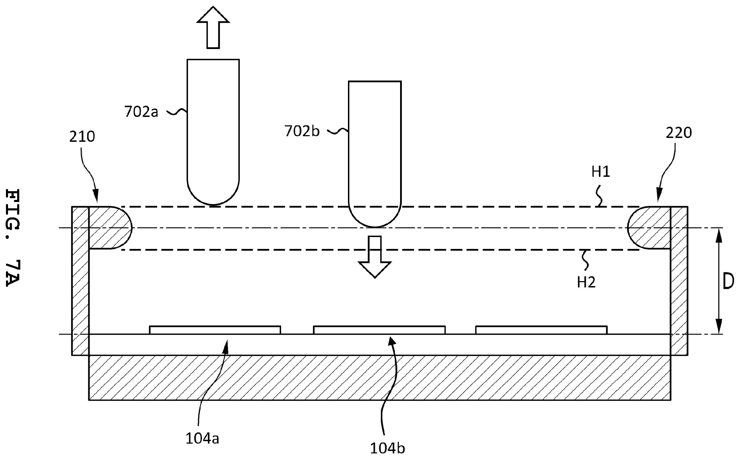

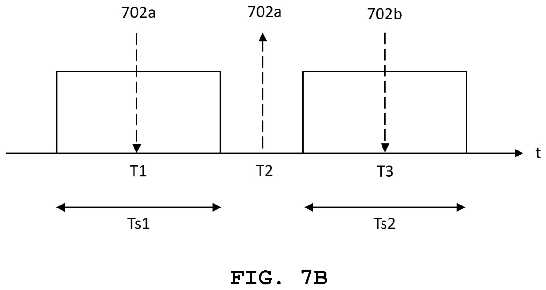

FIG. 7A is a view illustrating an operation of the non-contact destination floor input device 200 shown in FIG. 1 when a new object 702b enters a sensing area after an existing object 702a has departed from the sensing area, and FIG. 7B is a view illustrating entry times of the objects 702a and 702b.

When the object 702a enters the sensing area at time T1 during the sensing cycle (Ts1) and remains in the sensing area also during the sensing cycle (Ts2), and the object 702b enters the sensing area during the sensing cycle (Ts2), the entry of the object 702b is ignored. However, when the object 702a has entered the sensing area at time T1 during the sensing cycle (Ts1) and has been sensed by the non-contact input controller 230, but has departed from the sensing area at time T2 prior to the sensing cycle (Ts2), and then the object 702b enters the sensing area at time T3 during the sensing cycle (Ts2), the non-contact input controller 230 processes the entry of the object 702b as a valid input and performs an operation of selecting a touch button. Accordingly, the non-contact destination floor input device 200 allows registration of a new destination floor.

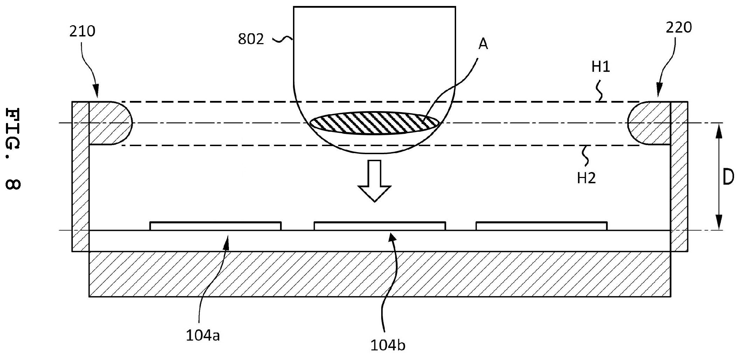

FIG. 8 is a view illustrating an operation of the non-contact destination floor input device 200 shown in FIG. 1 when a cross-sectional size (A) of an object that has entered a sensing area is equal to or larger than a predetermined size.

In this case, the non-contact input controller 230 determines that an object 802 is not a finger for designating a destination floor and ignores entry of the object 802. Accordingly, the non-contact destination floor input device 200 can prevent erroneous registration of a destination floor caused by entry of a body part other than a finger into the sensing area.

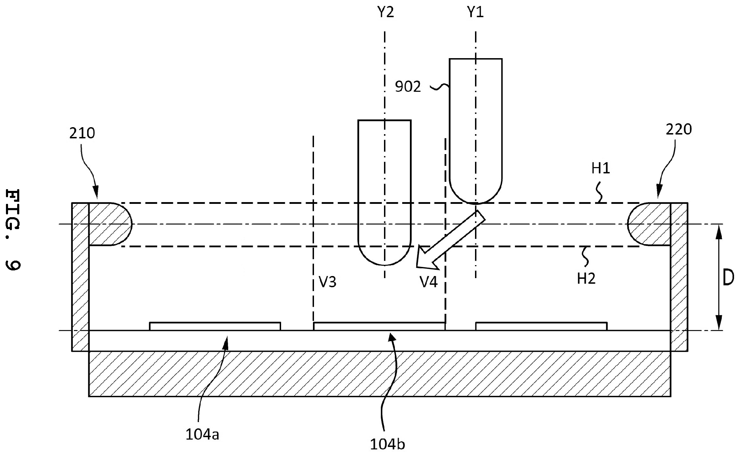

FIG. 9 is a view illustrating an operation of the non-contact destination floor input device 200 shown in FIG. 1 when an object 902 that has entered a sensing area is recognized as crossing a boundary of a region of the sensing area corresponding to a touch button.

The object 902 enters the sensing area at Y1, crosses a boundary (V4) of a region of the sensing area corresponding to the touch button 104b, and is finally positioned at Y2. Such movement of the object 902 is determined to be an exploratory hand motion of a visually impaired person, and accordingly the non-contact input controller 230 ignores the entry of the object 902, and causes the elevator to operate only by pressing of the object 902 against the touch buttons 104a and 104b.

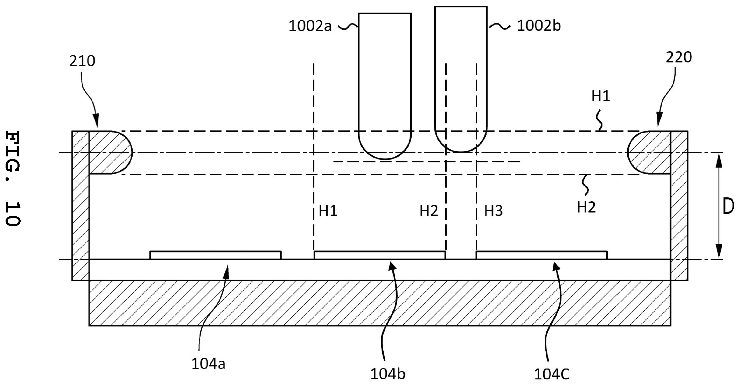

FIG. 10 is a view illustrating an operation of the non-contact destination floor input device 200 shown in FIG. 1 when two or more objects enter a sensing area at very short time intervals and at least one of the objects enters a region of the sensing area that does not correspond to any touch button.

When a difference between entry times of an object 1002a and an object 1002b is greater than a threshold time (Td), the objects are determined to be fingers of different persons, and when the difference between the entry times of the object 1002a and the object 1002b is less than the threshold time (Td), the objects are determined to be fingers of the same person. Here, the threshold time (Td) is shorter than the sensing time (Ts). When the object 1002a and the object 1002b enter the sensing area within the threshold time (Td), and the object 1002a enters a region of the sensing area (between H1 and H2) mapped to the touch button 104b but the object 1002b enters a region of the sensing area (between H2 and H3) mapped to a region between the touch button 104b and a touch button 104c, such movement of the objects 1002a and 1002b is determined to be an exploratory hand motion of a visually impaired person, and accordingly the non-contact input controller 230 ignores the entries of the objects 1002a and 1002b, and causes the elevator to operate only by pressing of the objects 1002a and 1002b against the touch buttons 104a, 104b, and 104c.

The embodiments of the present invention described above are merely illustrative, and those of ordinary skill in the art to which the present invention pertains will recognize that various modifications and other equivalent embodiments are possible therefrom. Therefore, it should be understood that the present invention is not limited to the forms mentioned in the foregoing detailed description. Accordingly, the true scope of technical protection of the present invention should be defined by the technical spirit of the appended claims. Furthermore, the present invention should be understood to include all modifications, equivalents, and substitutes within the spirit and scope of the present invention as defined by the appended claims.

## Claims

1. A non-contact destination floor input device for an elevator, the device comprising:
a proximity sensing module installed at a periphery of an elevator control panel having a plurality of touch buttons, the proximity sensing module recognizing entry of an object into a sensing area at a predetermined distance from the touch buttons; and
a non-contact input controller configured to receive a signal from the proximity sensing module, calculate an approach position of the object that has entered the sensing area, and cause at least one of the plurality of touch buttons to be selected based on a result of the calculation.

2. The destination floor input device of claim 1, wherein, when two or more objects enter the sensing area, the non-contact input controller processes only the object that first entered the sensing area as a valid input.

3. The destination floor input device of claim 1, wherein, when a second object enters the sensing area in a state in which entry of a first object into the sensing area has been recognized, the non-contact input controller ignores the entry of the second object.

4. The destination floor input device of claim 1, wherein, when a second object enters the sensing area in a state in which a first object has entered a region of the sensing area corresponding to an OPEN button among the plurality of touch buttons, the non-contact input controller processes the entry of the second object as a valid input.

5. The destination floor input device of claim 1, wherein, after all objects have departed from the sensing area, the non-contact input controller processes a subsequent entry of an object into the sensing area as a valid input.

6. The destination floor input device of claim 1, wherein, when a cross-sectional size of an object that has entered the sensing area is equal to or larger than a predetermined size, the non-contact input controller ignores the entry of the object.

7. The destination floor input device of claim 1, wherein, when the entered object is recognized as crossing a boundary of a region of the sensing area corresponding to one of the plurality of touch buttons, the non-contact input controller ignores the entry of the object.

8. The destination floor input device of claim 1, wherein, when two or more objects enter the sensing area within a predetermined time and at least one of the objects enters a region of the sensing area that does not correspond to any one of the plurality of touch buttons, the non-contact input controller ignores all entries of the two or more objects.
